# EUROPEAN PATENT APPLICATION

(11) **EP 4 807 789 A1**
(43) Date of publication of application: **16.09.2026**
(21) Application number: 25163275.8
(22) Date of filing: 12.03.2025
(51) Int. Cl.: H01L 21/67, H01L 21/683, H01L 21/687

(54) **SUBSTRATE HOLDER**

(71) Applicant: ASML Netherlands B.V., 5500 AH Veldhoven (NL)
(72) Inventor: MÜCK, Marcel, 5500 AH Veldhoven (NL); KLEMM, Hagen, William, 5500 AH Veldhoven (NL); FRANKE, René, 5500 AH Veldhoven (NL)
(74) Representative: ASML Netherlands B.V.

(57) **Abstract**

A substrate holder for a bonding tool that is configured to bond a first substrate to a second substrate, is configured to hold the first substrate and comprises: a plurality of burls protruding from a base surface of the substrate holder and configured to contact the first substrate, wherein the substrate holder is configured to clamp the first substrate to the substrate holder by a clamping force through the burls.

## Description

### FIELD OF INVENTION

The present invention relates to a substrate holder, a holding system and a method for holding a substrate.

### BACKGROUND

In the manufacture of integrated circuits (ICs), circuit features are formed on/in semiconductor substrates. To form circuit features on/in a semiconductor substrate, various processes may be performed such as: depositing a layer of photoresist on a surface on the semiconductor substrate; imparting of a pattern to the layer of photoresist using lithography; etching material away from the semiconductor substrate or layers deposited thereon, in accordance with the pattern imparted to the layer of photoresist during lithography; and modifying characteristics of the semiconductor substrate or the layers formed thereon, (e.g. through oxidation, doping, ion implantation, etc.).

To form some types of device, one semiconductor substrate (which may have circuit features formed thereon) may be bonded with another semiconductor substrate (which may also have circuit features formed therein/thereon). Bonding processes include die-to-die, die-to-wafer and wafer-to-wafer bonding processes. Wafer-to-wafer bonding involves whole wafers being permanently bonded together prior to dicing. In die-to-die bonding, an individual die (which may originate from a wafer that has been diced) may be bonded to another individual die (which may also originate from a wafer that has been diced. In die-to-wafer bonding, an individual die (which may originate from a wafer that has been diced) may be bonded to a whole wafer. In bonding process, a high accuracy and a high throughput are important.

The surfaces of the semiconductor substrate which are bonded together may comprise a plurality of metallic portions. The metallic portions may be configured such that, once the two substrates are bonded together, the two semiconductor substrates are in electrical contact with one another via the metallic portions. Thus, the circuit features of the two semiconductor substrates can operate together.

During typical bonding methods, distortions may be induced in the semiconductor substrates that are being bonded together. For example, distortions may be induced by the propagation of a bond front from a centrally-located bond initiation point to the edge of the substrate. These distortions may have a negative effect on the product that comprises the bonded semiconductor substrates. For example, distortion may result in misalignment of the metallic portions, which may mean that the product does not function as intended. This may mean that throughput is reduced, because a significant number of products are scrapped.

### SUMMARY OF THE INVENTION

An aim of the invention is to reduce distortion to bonded substrates.

An aspect of the present disclosure is a substrate holder for a bonding tool configured to bond a first substrate to a second substrate, the substrate holder configured to hold the first substrate and comprising:
a plurality of burls protruding from a base surface of the substrate holder and configured to contact the first substrate,
wherein the substrate holder is configured to clamp the first substrate to the substrate holder by a clamping force through the burls.

Another aspect of the present disclosure is a method for holding a first substrate to be bonded to a second substrate, the method comprising:
contacting the first substrate with a plurality of burls protruding from a base surface of the substrate holder; and
clamping the first substrate to the substrate holder by a clamping force through the burls.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings which are briefly described below.
Figure 1 depicts a lithographic apparatus together with other apparatuses forming a production facility for semiconductor devices.
Figure 2 is a diagram describing a present method of manufacturing integrated devices which utilizes the bonding of substrates.
Figure 3 schematically depicts a hybrid bonding process.
Figure 4A depicts the steps of a conventional bonding method. Figure 4B depicts the alignment of metallic portions of the two substrates at various stages of the conventional bonding method.
Figure 5 schematically depicts a substrate holder for a bonding tool.
Figure 6 schematically depicts the back surface of a substrate clamped to the substrate holder shown in Figure 5.
Figure 7 schematically depicts the back surface of a substrate held by an alternative substrate holder.
Figure 8 schematically depicts the displacement of the back surface shown in Figure 7 perpendicular to the back surface.
Figure 9 schematically depicts displacement of the back surface shown in Figure 7 within the plane of the back surface.
Figure 10 schematically depicts a plan view of the substrate holder shown in Figure 5.
Figure 11 schematically depicts an alternative substrate holder.
Figure 12 schematically depicts an optional feature of the substrate holder.
Figure 13 is a graph showing the relationship between radial position and the bond gap.
Figure 14 is a graph showing the relationship between radial position and the clamping force.
Figure 15 is a graph showing the relationship between radial position and the bond force.
Figure 16 schematically depicts detection of particles within a bond.

### DETAILED DESCRIPTION

Before describing embodiments of the invention in detail, it is instructive to present an example environment in which embodiments of the present invention may be implemented.

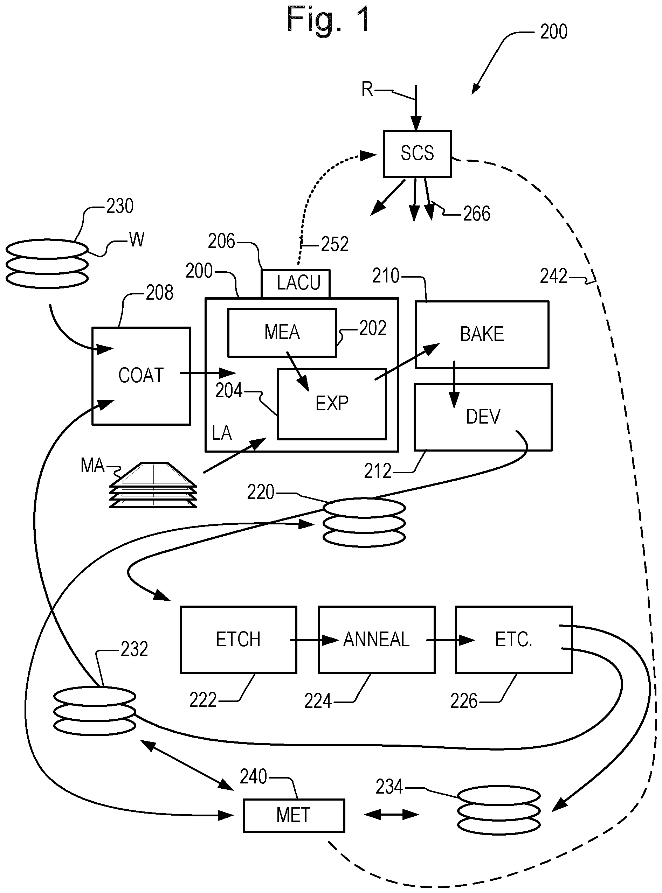

Figure 1 at 200 shows a lithographic apparatus LA as part of an industrial production facility implementing a high-volume, lithographic manufacturing process. In the present example, the manufacturing process is adapted for the manufacture of semiconductor products (integrated circuits) on semiconductor substrates (e.g. semiconductor wafers). The products may form part of an electronic device. The skilled person will appreciate that a wide variety of products can be manufactured by processing different types of substrates in variants of this process. The production of semiconductor products is used purely as an example which has great commercial significance today.

Within the lithographic apparatus (or "litho tool" for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore, some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly, a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

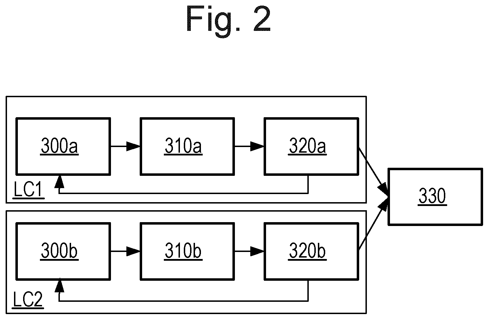

Figure 2 schematically depicts a device manufacturing arrangement/method for making bonded substrates (and therefore ICs based on bonded substrates) comprising a first manufacturing lithocell LC1 and a second manufacturing lithocell LC2. Within each lithocell is a lithographic processing system 300a, 300b and a first metrology system 310a, 310b. The lithographic processing system 300a, 300b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 320a, 320b in communication with its respective lithographic processing system 300a, 300b and metrology system 310a, 310b, so that results, designs, data, etc. of the lithographic processing system 300a, 300b and/or the metrology apparatus 310a, 310b may be stored and analyzed by the software application 320a, 320b at the same time or different times.

Once pairs of substrates (e.g. wafers) are completed from each of lithocell LC1 and lithocell LC2, they may be bonded within a bonding tool 330 to obtain a bonded wafer. A pair of substrates from a single lithocell (e.g. lithocell LC1) may also be bonded together. Bonding in this context may be wafer-to-wafer bonding where whole wafers are aligned and bonded together such that individual dies on each wafer are aligned. The concept of wafer-to-wafer bonding is known and used in many IC manufacturing processes. Bonding in this context may also be wafer-to-die or die-to-wafer bonding, in which an individual die is bonded to a wafer. Bonding in this context may also be die-to-die bonding, in which one individual die is bonded to another individual die. As used herein, the term "bonding method" is used to mean methods of bonding of one semiconductor substrate to another semiconductor substrate. The term "bonding method" is used to cover the bonding of one wafer to another wafer, of one die to a wafer, and of one die to another die. Further, as used herein (unless otherwise specified), the term "substrate" means "semiconductor substrate", which covers both wafers and dies.

The bonding tool 330 may comprise a bonding alignment device for aligning the substrates together for bonding. For example, the bonding tool 330 may perform pre-align using box-in-box marks provided to substrates (e.g., one box on each substrate), with visual inspection of marks used for alignment quality/ position control. Another method uses two imaging sensors (e.g., face to face) which are first calibrated together to find their relative positions; each sensor is then used to separately align a respective substrate to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 300a and 300b may comprise different tools or the same tools within each respective system. Similarly, metrology apparatuses 310 and 310b may be the same apparatus or different apparatuses. The software application 320a, 320b may be comprised within one or both of the respective lithographic processing systems 300a, 300b and/or one or both of the first metrology systems 310a, 310b, or elsewhere.

Once bonded, the bonded substrate may be subject to further lithographic patterning and processing. As such, alignment will be performed on the bonded substrate; e.g., for aligning the substrate and determining feed-forward corrections based on measured grid deformities. Also, post-exposure metrology, such as overlay metrology, may be performed on the bonded substrate after exposure; e.g., to determine feedback corrections for subsequent substrates.

At present, various bonding techniques have been implemented to bond semiconductor substrates (e.g. wafers). Among existing bonding techniques, fusion bonding and hybrid bonding are widely employed for bonding semiconductor substrates. Fusion bonding enables permanent connection via dielectric layers on each bonding semiconductor substrate and provides a good bonding strength with a high bonding yield. The dielectric layers may comprise, for example, silicon oxide, e.g. activated silicon oxide of the form SiOxHy. Additionally or alternatively, the dielectric layers may comprise, for example, SiON, e.g. activated SiON of the form SiOxNyHz. The activation of the silicon oxide or the SiON may comprise plasma activation or activation comprising use of a hydrogen radical generator or exposure to UV light.

Typically, the fusion bonding process comprises three main steps: 1) surface preparation which may include surface planarization, cleaning and activation; 2) pre-bonding at room temperature which may include aligning the two bonding surfaces; and 3) annealing (or heat treatment) at elevated temperatures (e.g., 200°C to 500°C). In the fusion bonding process, spontaneous adhesion of the two bonding surfaces occurs at room temperature via Van der Waals forces between the two bonding surfaces and via hydrogen bridge bonds of chemisorbed water molecules. The hydrogen bridge bonds of chemisorbed water molecules may react during the annealing step to form covalent siloxane bonds. The spontaneous adhesion of the two bonding surfaces (e.g. through Van der Waals forces and the like) may be referred to as optical bonding. Further information about the fusion bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

Hybrid bonding combines fusion bonding and metal diffusion bonding into a single bonding process and enables formation of dielectric-to-dielectric and metal-to-metal bonds between the bonding surfaces of the two substrates. The metal-to-metal bonds between the two substrates may provide one or both of: (a) increased bond strength between the two substrates; and (b) electrical connection between the two substrates (e.g. electrical connection between a functional device formed on one substrate and another functional device formed on another substrate).

In a hybrid bonding process, metal is embedded in bonding surfaces of the substrates that are to be bonded together. The metal may be copper, gold, or any other metal or metal alloy with a coefficient of thermal expansion that is greater than the coefficient of thermal expansion of the material from which the dielectric layer is formed. The metal may be embedded in the dielectric layer of the substrates that are to be bonded together. The metal embedded in the substrates may be in the form of a plurality of metallic portions (which may be referred to as metallic pads) distributed across the substrates (e.g. distributed across the dielectric layer of the substrates). The metallic portions may be formed in a surface preparation step of the hybrid bonding method. For example, the metallic pads may be formed by etching the dielectric layer on the substrate (e.g., to create vias to the metal below) and electroplating (or electrochemical deposition (ECD) of) at least part of the etched dielectric layer to form metal pads therewithin. The bonding surface of a substrate may also be referred to as a joining surface of the substrate.

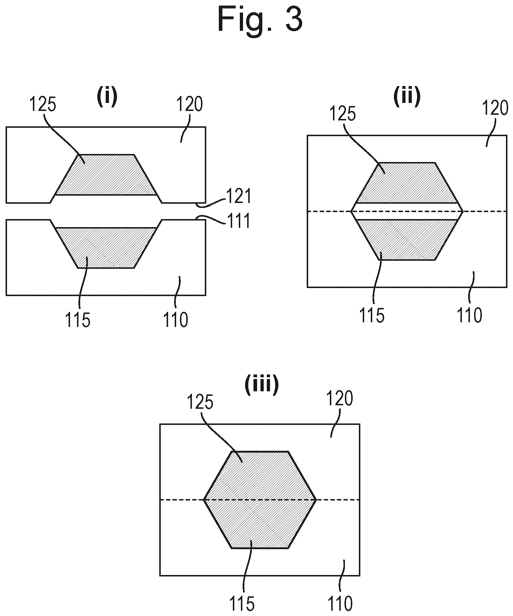

Similarly to the fusion bonding process, the hybrid bonding process also comprises the following three main steps: 1) surface preparation (in which the metallic portions may be formed, as described above); 2) pre-bonding at room temperature; and 3) annealing (or heat treatment) at elevated temperatures. Steps (2) and (3) are schematically depicted in Figure 3, which depicts a metallic portion 115 in a first substrate 110 and a metallic portion 125 in a second substrate 120. The single metallic portion on each of the first and second substrate 110, 120 is shown to explain the hybrid bonding process, and is representative of a plurality of metallic portions 115, 125.

At stage (i) in Figure 3, a bonding surface 111 of the first substrate 110 is separated (e.g. spaced apart from) from a bonding surface 121 of the second substrate 120. The bonding surface 111 of the first substrate 110 may be formed at least partially by a dielectric layer (not shown). The metallic portion 115 may be recessed below the bonding surface 121, but exposed at the bonding surface 121 (e.g. not covered by the dielectric layer). The bonding surface 121 of the second substrate 120 may be formed at least partially by a dielectric layer (not shown). The metallic portion 125 may be recessed below the bonding surface 121, but exposed at the bonding surface 121 (e.g. not covered by the dielectric layer).

In the hybrid bonding process, the two substrates 110, 120 may be aligned with one another. Then, the two substrates 110, 120 may be brought together such that the bonding surfaces 111, 121 come into contact, and are spontaneously bonded together (e.g. by optical bonding). At stage (ii) in Figure 3) the two substrates 110, 120 have been brought into contact with one another. At this point in the process, the metallic portion 115 of the first substrate 110 may not be bonded with (or in contact with) the metallic portion 125 of the second substrate 120. This may be because the metallic portions 115, 125 are recessed below the respective bonding surfaces 111, 121, as described above. By recessing the metallic portions 115, 125 below the respective bonding surfaces 111, 121, the metallic portions 115, 125 do not interfere with the initial optical bonding that occurs between the (dielectric) bonding surfaces 111, 121.

At stage (iii) in Figure 3, the two substrates 110, 120 have been subjected to an annealing (or heat treatment) step. As described above, the annealing (or heat treatment) transfers hydrogen bridge bonds to covalent siloxane bonds. Further, the heating of the metallic portions 115, 125 causes the metallic portions 115, 125 to expand up to or beyond the level of the respective bonding surfaces 111, 121. Thus, the metallic portions 115, 125 come into contact with one another. Where the metallic portions 115, 125 come into contact with one another, metal diffusion bonds may be formed. Further information about the hybrid bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

In many fusion or hybrid bonding applications, intermediate layers (e.g., silicon dioxide (SiO2), silicon carbon nitride (SiCN), silicon oxynitride (SiON)) are used to enhance bonding strength.

The present disclosure focuses primarily on an example involving fusion bonding. However, as will be appreciated, the techniques disclosed herein are equally applicable to diffusion bonding.

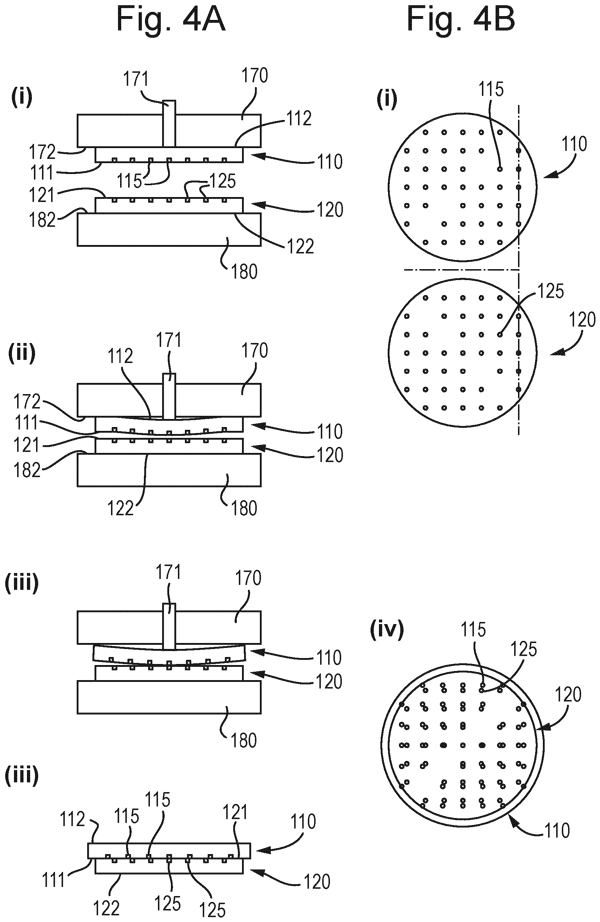

A conventional bonding method will now be described with reference to Figures 4A and 4B. The bonding method depicted in Figure 4A is a method for bonding a first semiconductor substrate 110 and a second semiconductor substrate 120. The first semiconductor substrate 110 comprises a bonding surface 111 and a plurality of metallic portions 115 distributed across the bonding surface 111. The second semiconductor substrate 120 also comprises a bonding surface 121 and a plurality of metallic portions 125 distributed across the bonding surface 121. This has been described in detail above.

In step (i) depicted in Figure 4A the first semiconductor substrate 110 is clamped to a first substrate holder 170. Specifically, a back surface 112 of the first semiconductor substrate 110 is in contact with a clamping surface 172 of the first substrate holder 170. As used in the present disclosure, the "back surface" of a substrate is a surface which is opposite to the bonding surface. The second substrate 120 has a back surface 122.

The clamping surface 172 of the first substrate holder 170 may comprise a plurality of support protrusions ("burls", not shown in the Figures). The back surface 112 of the first semiconductor substrate 110 may be supported on distal ends of the plurality of support protrusions. The first substrate holder 170 may be an electrostatic clamp comprising one or more electrodes (not shown) configured to apply an electrostatic clamping force to the first semiconductor substrate 110 to clamp the first semiconductor substrate 110 to the first substrate holder 170. Alternatively, the first substrate holder 170 may be a vacuum clamp. By contacting the back surface 112 of the first semiconductor substrate, the support protrusions may prevent the first semiconductor substrate moving towards the first substrate holder 170 under the influence of the clamping force exerted by the first substrate holder 170.

The second semiconductor substrate 120 may be clamped to a second substrate holder 180 in substantially the same way as the first substrate 110 is clamped to the first substrate holder 170. The first substrate holder 170 and the second substrate holder 180 may be arranged such that the bonding surfaces 111, 121 of the first and second substrates 110, 120 face one another.

As shown in Figure 4B, during step (i) (i.e. before the first substrate 110 is brought into contact with the second substrate 120), the metallic portions 115 on the first substrate 110 may be substantially aligned with the metallic portions 125 portions on the second substrate 120.

The first substrate holder 170 may comprise a pushing means configured to push the first substrate 110 towards the second substrate 120. As shown in Figure 4A, the pushing means may comprise a pin 171. The pin 171 extends through a body of the first substrate holder 170. The pin 171 is extensible and retractable, so that the pin 171 can push the first substrate 110 towards the second substrate 120. The pin 171 may be configured to initiate contact between the first substrate 110 and the second substrate 120. Thus, the pin 171 may be configured to initiate spontaneous bonding between the first substrate 110 and the second substrate 120.

The pin 171 is located in a central (e.g. radially central) portion of the first substrate holder 170, such that the pin 171 pushes against a central (e.g. radially central) portion of the back surface 112 of the first substrate 110. In the example depicted in Figure 4A, the second substrate holder 180 does not comprise a pushing means.

In steps (ii) and (iii), the first substrate 110 is brought into contact with the second substrate 120. To bring the first substrate into contact which the second substrate 120, the clamping force (e.g. electrostatic clamping force or vacuum clamping force) exerted on the first substrate 110 by the first substrate holder 170 (e.g. by one or more electrodes in the first substrate holder 170 or by a pressure difference) is released or reduced. Simultaneously, the pin 171 is extended so as to apply a pushing force to the back surface 112 of the first substrate 110.

As the pin 171 pushes against the central portion of the first substrate 110, the central portion of the first substrate 110 moves towards the second substrate 120. Thus, a central portion of the bonding surface 111 of the first substrate 110 comes into contact with the bonding surface 121 of the second substrate. As the central portion of the bonding surface 111 of the first substrate 110 comes into contact with the bonding surface 121 of the second substrate 120, spontaneous bonding (e.g. by Van der Waal's forces and the like) occurs therebetween. This spontaneous bonding causes the first substrate 110 to be pulled down onto the second substrate 120. This occurs first at the radially-central portion of the first substrate 110, and then propagates radially outwards. The radially outward propagation of the region at which the bonding surface 111 of the first substrate 110 is bonded to the bonding surface 121 of the second substrate 120 is referred to as a bond front (or "bond wave"). The bond wave propagates from the point of bond initiation (which corresponds to the position of the pin 171) to the edges of the first semiconductor substrate 110. As the first substrate 110 is pulled down onto the second substrate 120, air (or other gas) between the two substrates 110, 120 is displaced.

The speed at which the bond front propagates over the first substrate 110 may depend on various factors, such as: surrounding atmosphere pressure, temperature, the surrounding gas type, the surrounding gas density, patterns in the first substrate 110; crystal orientations in the first substrate 110; and pre-existing tensions in the first substrate 110. These factors may not be uniform over the surface of the first substrate 110. Consequently, the propagation of the bond front may not occur uniformly. A non-uniform propagation of the bond front may lead to local tensions in the first substrate 110, which in turn lead to distortions in the first substrate 110. These distortions may have a negative effect on the product that comprises the bonded semiconductor substrates. For example, distortions may mean that the product does not function as intended. It may not be possible to correct the distortions in subsequent steps of the manufacturing process. Consequently, the occurrence of distortion in the first substrate 110 during the bonding method may mean that throughput is reduced, because a significant number of products are scrapped.

Moreover, even if the bond front is substantially uniform, the propagation of the bond front from the central initiation point to the edges of the substrate may lead to an expansion (e.g. a stretch) of the first substrate 110 in the radial direction. Consequently, at step (iv) in Figure 4A-where the first substrate 110 and the second substrate 120 have been bonded together and removed from the first and second substrate holder 170, 180-the metallic portions 115 of the first substrate may not be aligned with the metallic portions of 125 of the second substrate 120. Specifically, the metallic portions 115 of the first substrate 110 may be displaced radially outwards compared to the metallic portions 125 of the second substrate 120.

Once the first substrate 110 is fully in contact with second substrate 120 (and therefore the first substrate 110 is bonded to the second substrate 120), the first substrate 110 may not be able to contract (i.e. relax) back to its original dimensions. Thus, the first substrate 110 may remain in its radially-expanded form. Thus, the metallic portions of the first substrate 110 may remain misaligned relative to the metallic portions of the second substrate 120. Misalignment of the metallic portions may mean that the product does not function as intended. This may mean that throughput is reduced, because a significant number of products are scrapped. It is noted that the metallic portions may be very small relative to the substrate W, and any (e.g. even partial) misalignment between the metallic portions may lead to a worsening of the performance of the product.

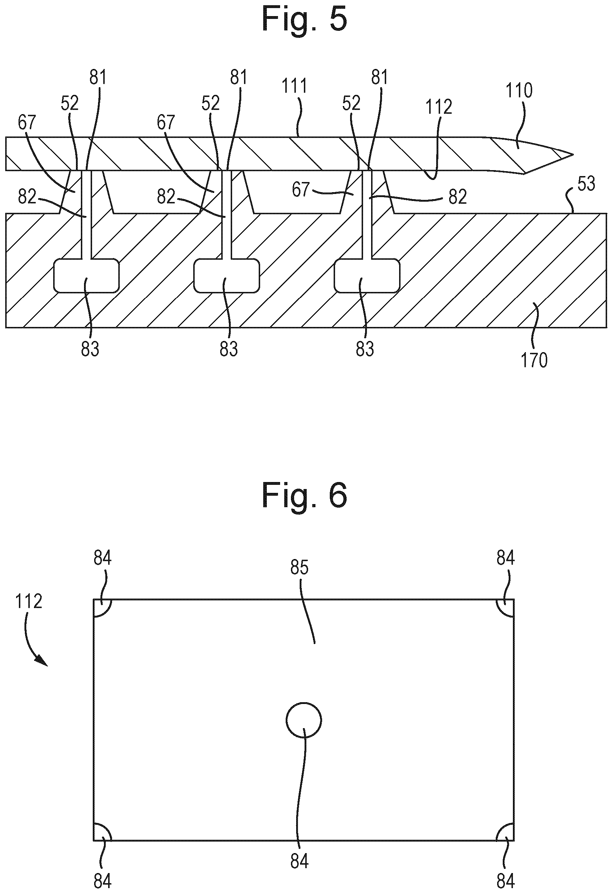

Figure 5 schematically depicts a substrate holder 170. The substrate holder 170 may be used as the first substrate holder and/or the second substrate holder described with reference to Figure 4, for example. The substrate holder 170 is configured to support a substrate 110 such as the first substrate or the second substrate described with reference to Figure 4.

The substrate holder 170 is for a bonding tool. A bonding tool is configured to bond a first substrate 110 to a second substrate 120. The bonding may be die-to-wafer bonding, die-to-die bonding or wafer-to-wafer bonding, for example. The substrate holder 170 may be comprised in the bonding tool.

In an embodiment the bonding tool comprises a holding system. The holding system may comprise a plurality of the substrate holder 170. For example, one substrate holder 170 may be configured to hold a first substrate, while another substrate holder is configured to hold a second substrate. The first substrate and the second substrate are to be bonded all together. Alternatively, the substrate holder 170 may be configured to hold the substrate 110, while a different apparatus holds the second substrate that is to be bonded to the substrate 110. For example, a stage configured to move a die from a donor substrate to the substrate 110 (which may be an acceptor substrate) may be configured to hold the second substrate 120 (e.g. a die) to be bonded to the substrate 110 supported by the substrate holder 170.

As shown in Figure 5, in an embodiment the substrate holder 170 comprises a plurality of burls 67. The burls 67 are configured to protrude from a base surface 53 of the substrate holder 170. In an embodiment the base surface 53 is substantially planar. The burls 67 are arranged to protrude from the base surface 53 towards the back surface 112 of the substrate 110 that is supported by the substrate holder 170.

As shown in Figure 5, the burls 67 have respective distal ends 52. The back surface 112 of the substrate 110 may be supported by the distal ends 52 of the burls 67.

By providing the burls 67 for supporting the back surface 112 of the substrate 110, the overall surface area of contact between the substrate holder 170 and the back surface 112 of the substrate 110 may be reduced. By reducing the surface area of the contact, the possibility of a particle being clamped between the substrate 110 and the substrate holder 170 may be reduced. In an embodiment the burls 67 are arranged in a pattern across the substrate holder 170.

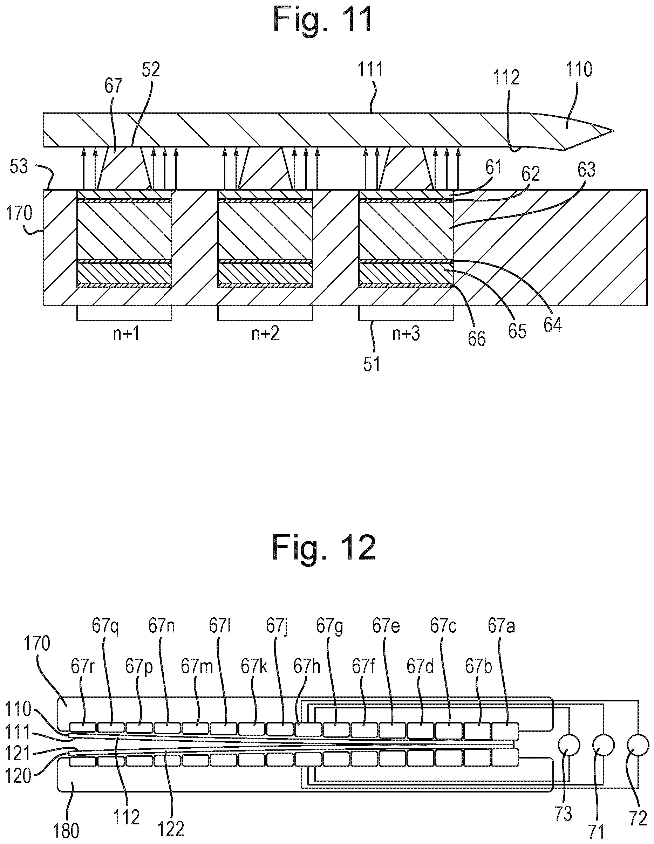

As shown in Figure 5, in an embodiment the burls 67 are arranged such that the distal ends 52 form a supporting surface for supporting the substrate 110. The supporting surface may be generally planar. In an embodiment the burls 67 are controllable such that the supporting surface formed by the distal ends 52 is non-planar. This is explained in further detail with reference to Figure 11 and Figure 12.

In an embodiment the substrate holder 170 is configured to clamp the substrate 110 to the substrate holder 170. The substrate holder 170 is configured to apply a clamping force for clamping the substrate 110 to the substrate holder 170. The clamping force may be pneumatic and/or electrostatic. Figure 5 shows an arrangement in which the clamping force is pneumatic (i.e. vacuum clamping).

As shown in Figure 5, in an embodiment the substrate holder 170 is configured to clamp the substrate 110 via a clamping force through the burls 67. That is, the clamping force for clamping the substrate 110 is exerted through the burls 67, rather than only in areas between the burls 67.

As shown in Figure 5, in an embodiment the burls 67 comprise vacuum channels 82. The vacuum channels 82 may be for applying the clamping force. As shown in Figure 5, in an embodiment the distal ends 52 of the burls 67 are provided with openings 81. The openings 81 may correspond to the ends of respective vacuum channels 82. In an embodiment the substrate holder 170 is configured to apply an under pressure to the back surface 112 of the substrate 110 via the openings 81 and the vacuum channels 82.

As shown in Figure 5, in an embodiment the back surface 112 substantially covers the openings 81 when the substrate 110 is being held by the substrate holder 170. When the substrate 110 is not being held by the substrate holder 170, the openings 81 are exposed to the environment. As shown in Figure 5, in an embodiment the openings 81 are located distal to the base surface 53 of the substrate holder 170. In an embodiment the vacuum channels 82 extend at least partly along the direction of protrusion of the burls 67.

As shown in Figure 5, in an embodiment the substrate holder 170 comprises one or more vacuum chambers 83. In an embodiment the vacuum channels 82 are configured to fluidly communicate the openings 81 with respective vacuum chambers 83. In an embodiment, a plurality of the vacuum chambers 83 may be in fluid communication with each other. Alternatively, the vacuum chambers 83 may be separate from each other.

Figure 5 schematically shows three burls 67, for example corresponding to the outermost three burls 67 within a cross-section of the substrate holder 170. Figure 5 shows only the outermost part of the substrate holder 170 and the outermost part of the substrate 110. A cross-section of the whole of the substrate holder 170 may have a greater number of burls 67.

As shown in Figure 5, in an embodiment the burls 67 may correspond to different radii of the substrate holder 170. This means that the burls 67 are located at different radial distances from the centre of the base surface 53 of the substrate holder 170. For example, in plan view the substrate holder 170 may have a base surface that is substantially circular. A radial direction may be defined from the centre of the base surface 53 towards the periphery of the substrate holder 170.

In an embodiment a plurality of burls 67 corresponding to the same radial distance from the centre of the substrate 170 are provided with vacuum channels 82 connected to the same vacuum chamber 83. For example, the vacuum chamber 83 may have an annular shape that extends in a circumferential direction of the substrate holder 170. In an embodiment, each ring of burls 67 corresponds to a separate vacuum chamber 83. By providing separate vacuum chambers 83, the clamping force applied through the burls 67 corresponding to different vacuum chambers 83 may be controlled independently of each other. In an embodiment, a plurality of rings of burls 67 are provided with vacuum channels 82 that fluidly communicate with the same vacuum chamber 83. In an embodiment, a ring of burls 67 is divided into a plurality of segments, each segment corresponding to a separate vacuum chamber 83. Other groupings of burls 67 for independent clamping force control may be provided.

In an embodiment, one or more sources of under pressure (e.g. vacuum supplies) may be connected to the vacuum chambers 83 so as to apply the under pressure at the openings 81. In an embodiment the substrate holder 170 comprises a controller. The controller is configured to control the clamping force applied through the burls 67. By controlling the clamping force, the bonding between the first substrate and the second substrate may be controlled. For example, the propagation of the bond front may be controlled.

As shown in Figure 5, in an embodiment the burls 67 (which may be referred to as contact pins) provided the clamping force. In an embodiment the burls 67 provide the release of clamping. This is different from the clamping force acting between the burls 67. An embodiment of the invention is expected to reduced misalignment within the bond. An embodiment of the invention is expected to reduce distortion of the substrate 110 in the bond. An embodiment of the invention is expected to reduce undesirable lateral displacement during bonding.

Figure 6 schematically depicts the back surface 112 of the substrate 110 held by the substrate holder 170 shown in Figure 5, for example. As shown in Figure 6, the back surface 112 comprises clamping force regions 84 and a force-free region 85. The clamping force regions 84 correspond to parts of the back surface 112 at which the clamping force is directly applied by the substrate holder 170. The force-free region 85 corresponds to parts of the back surface 112 at which the clamping force is not applied directly.

In the arrangement shown in Figure 6, the clamping force regions 84 correspond to the locations of the distal ends 52 of the burls 67 of the substrate holder 170. Figure 6 shows an arrangement in which a burl 67 is located at the centre of the shown portion of the back surface 112, and a further four burls 67 are clamping at the four corners of the portion of the back surface 112 shown in Figure 6. The force-free region 85 corresponds to the area between the distal ends 52 of the burls 67.

By providing the clamping force on the burls, the displacement of the back surface 112 as a result of the clamping is negligible, by substantially zero. Similarly, undesirable displacement within the plane of the back surface 112 is negligible, i.e. substantially zero. As a result, undesirable distortion of the substrate 110 and the bonding surface 111 of the substrate 110 as a result of clamping is negligible. By reducing distortion, alignment of the metallic portions between the substrates to be bonded together is improved. An embodiment of the invention is expected to increase the likelihood that the product of the bonding functions as intended. An embodiment of the invention is expected to increase throughput, by reducing the number of products that are scrapped.

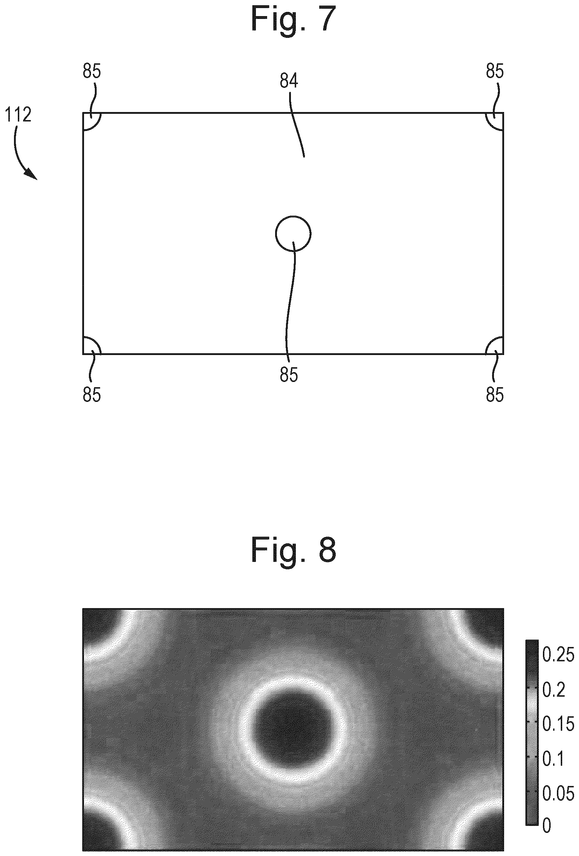

Figure 7 schematically shows the back surface 112 of a substrate clamped by an alternative substrate holder. In the alternative substrate holder, the clamping force for clamping the substrate is applied between the burls. As a result, Figure 7 shows that the clamping force region 84 is present between the burls. The force-free regions 85 are present where the distal ends of the burls contact the back surface 112. In other words, Figure 7 shows the opposite arrangement from Figure 6. In Figure 7, the clamping force is between the burls, whereas in Figure 6 the clamping force is on the burls.

Figure 8 is a graph showing the relationship between position along the back surface 112 (of Figure 7) and displacement in the direction perpendicular to the back surface 112. As shown in Figure 8, when the clamping force is applied between the burls, there is a measurable displacement perpendicular to the plane of the back surface 112. The back surface 112 is pulled towards the substrate holder 170. The force acts between the burls, which causes displacement of the back surface 112 between the burls. This displacement may be referred to as sagging. This sagging can cause undesirable distortion of the bonding surface 111, leading to misalignment and errors in the bonding process.

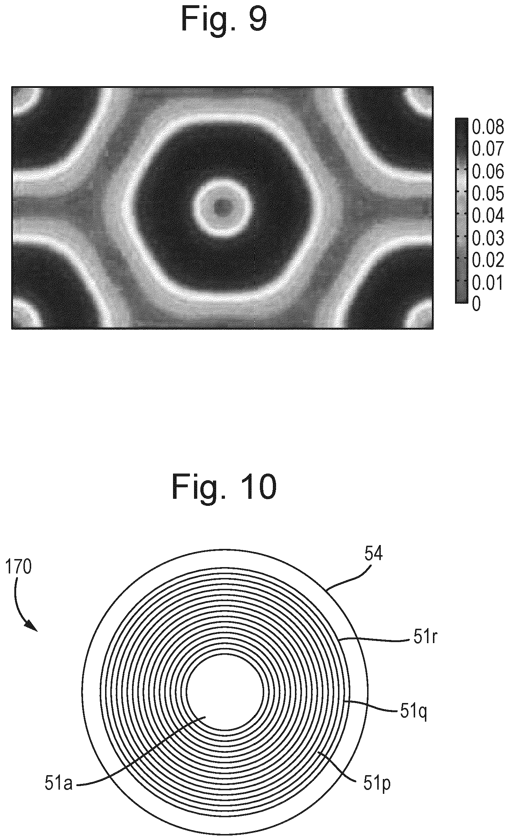

Figure 9 is a graph showing the relationship between position along the back surface 112 and lateral displacement within the plane of the back surface 112. As shown in Figure 9, when the clamping force is applied between the burls, there is a measurable displacement in the lateral direction. An embodiment of the invention is expected to substantially eliminate the undesirable displacement in the lateral and perpendicular directions.

By providing the clamping force on the burls 67, stress induced by the clamping on the substrate 110 may be reduced (or substantially eliminated).

Figure 10 schematically depicts a plan view of the substrate holder 170. As shown in Figure 10, in an embodiment the substrate holder 170 comprises a plurality of independently controllable regions 51. In Figure 10, only four of the regions are labelled, namely the central independently controllable region 51a and the three outermost independently controllable regions 51p, 51q, 51r. Figure 10 also indicates the outer periphery (or outer rim) 54 of the substrate holder 170.

Each independently controllable region 51 has one or more properties that can be controlled independently of the other independently controllable regions 51. The property may be the clamping force. For example, the clamping force of the central independently controllable region 51a may be controlled independently of the clamping force in the three outermost independently controllable regions 51p, 51q, 51r.

As shown in Figure 10, in an embodiment the independently controllable regions 51 correspond to different radii of the substrate holder 170. In the arrangement shown in Figure 10, the independently controllable regions 51 are substantially annular. In an alternative embodiment, each of the independently controllable regions 51 shown in Figure 10 is divided into a plurality of segments, where each segment has a property (e.g. clamping force) that is independently controllable relative to the other segments and the segments of other regions.

It is not essential for the regions to be annular or segment shaped. In an alternative arrangement, the independently controllable regions 51 are substantially hexagonal, with the substrate holder 170 divided into a pattern of hexagonal regions. Other patterns of regions are also possible.

By increasing the number of independently controllable regions 51, the bonding between the first substrate and the second substrate may be controlled more precisely. For example, the propagation of the bond front may be controlled more precisely.

In an embodiment the controller is configured to control the clamping force (e.g. of the plurality of independently controllable regions 51) so as to adjust the progress of the bond front, for example for local control of the bond gap. The bond gap is the gap between the first substrate and the second substrate during the bonding. During the bonding, the bond gap is different for different portions of the first substrate and the second substrate. Where the first substrate and the second substrate are bonded, the bond gap is zero. The bond front corresponds to the location where the bond gap changes from being zero to non-zero. Close to the bond front, the bond gap is very small. Further away from the bond front, the bond gap generally increases in size.

In an embodiment the controller is configured to control the clamping force so as to control the bond speed. The bond speed corresponds to the speed of propagation of the bond front. For example, the controller may be configured to reduce the bond speed. By reducing the bond speed, the possibility of gas being undesirably trapped in the bond between the first substrate and the second substrate may be reduced. By reducing the bond speed, the stress remaining in the bonded substrates may be reduced. For example, the possibility of random bond contacts being formed may be reduced, thereby reducing the stress in the bonded product. In an embodiment the controller is configured to increase the bond speed. By increasing the bond speed, the throughput of the bonding process may be increased. An embodiment of the invention is expected to improve control over the bond speed.

In an embodiment, the controller is configured to control the clamping force so as to move voids. Voids are where the first substrate and the second substrate are not in contact with each other, for example due to gas or a vacuum being trapped between the first substrate and the second substrate. In an embodiment the controller is configured to control the clamping force so as to control compression between the first substrate and the second substrate so as to move one or more voids.

Figure 11 schematically depicts optional features of the substrate holder 170. Features of the substrate holder 170 shown in Figure 11 that are described in relation to other Figures are not repeated here, for brevity.

In the arrangement shown in Figure 5, the clamping force is applied pneumatically. That is, vacuum clamping is used. However, it is not essential for the clamping force to be a vacuum clamping force. In an alternative embodiment the substrate holder 170 is configured to apply the clamping force electrostatically. The substrate holder 170 may be referred to as an electrostatic clamp. Figure 11 schematically depicts the substrate holder 170 comprising electrostatic clamping.

As shown in Figure 11, in an embodiment the substrate holder 170 comprises a plurality of clamping electrodes 62. The clamping electrodes 62 may be embedded within the main body of the substrate holder 170. The clamping electrodes 62 may be distanced from the base surface 53 of the substrate holder 170. By covering the clamping electrodes 62, the possibility of undesirable electrical breakdown may be reduced.

As shown in Figure 11, in an embodiment the substrate holder 170 comprises one or more insulators 61. The insulators 61 are located between the clamping electrodes 62 and the burls 67. The insulators 61 are configured to insulate the clamping electrodes 62 from the external environment. As shown in Figure 11, in an embodiment a plurality of insulators 61 are provided. Figure 11 shows insulators 61 for respective burls 67. In an embodiment an insulator 61 extends under a plurality of the burls 67. For example, an insulator 61 may correspond to all of the burls 67 within an independently controllable region 61.

As shown in Figure 11, in an embodiment a plurality of clamping electrodes 62 are provided for respective burls 67. In an embodiment a plurality of the burls 67 are provided with individual clamping electrodes 62. This allows the clamping force to be controlled independently for each of these burls 67. In an alternative embodiment, a clamping electrode 62 corresponds to a plurality of burls 67. For example, the burls 67 may be grouped into groups, with each group of burls 67 having an associated clamping electrode 62.

For example, in an embodiment the burls 67 within an independently controllable region 51 are associated with the same clamping electrode 62. In an embodiment there are a plurality of independently controllable clamping electrodes 62 located such that the burls 67 are between the clamping electrodes 62 and the clamped substrate. The burls 67 are between the clamping electrodes 62 and the clamped substrate in the direction perpendicular to the surface of the clamped substrate, which may be referred to as the Z-direction.

In an embodiment the substrate holder 170 comprises one or more electrical power supplies. The electrical power supply is configured to supply electrical power to the clamping electrodes 62. For example, the electrical power supply may apply a controllable electric potential to the clamping electrodes 62 so as to control the electrostatic clamping force.

When an electric potential is applied to the clamping electrode 62, a potential difference is applied between the clamping electrode 62 and the back surface 112 of the substrate 110. The potential difference results in an electric field being formed, as shown by the arrows in Figure 11 between the base surface 53 and the back surface 112 of the substrate 110. In an embodiment the electric field penetrates the burls 67. The clamping force is applied to the substrate 110 through the burls 67. As shown in Figure 11, there may be some clamping force applied outside the burls 67, for example in the region immediately surrounding the burls 67.

In an embodiment the controller is configured to control the electrical power supplies so as to control the electrostatic clamping force.

In an alternative embodiment, the substrate holder 170 may be configured to apply both an electrostatic clamping force and a vacuum clamping force. For example, the openings 81 and vacuum channels 82 shown in Figure 5 may be provided in the substrate holder 170 shown in Figure 11.

By reducing the number of independently controllable regions 51, the complexity of the substrate holder 170 may be reduced. The possibility of a component of the substrate holder 170 failing during use may be reduced.

As shown in Figure 11, in an embodiment the substrate holder 170 comprises a plurality of sensors 65. The sensors 65 are configured to sense a force applied to the substrate 110 held by the substrate holder 170. For example, during bonding of the first substrate to the second substrate, a bond force may be applied to the bonding surface 111 of the substrate 110. The bond force may be an adhesive force experienced by the substrate 110. Close to the bond front but where the first substrate and the second substrate remain separated, the substrate 110 may experience a relatively high bond force. Further away from the bond front, the bond force may be reduced. An embodiment of the invention is expected to make it possible to measure the bond force.

As shown in Figure 11, in an embodiment a plurality of sensors 65 are provided for respective burls 67. The sensors 65 may be located under the respective burls 67. In an embodiment each burl 67 is provided with a corresponding sensor 65. In an alternative arrangement, a plurality of burls 67 are provided with a common sensor 65. For example, the burls 67 may be grouped into groups, with each group of burls 67 having a common sensor 65. In an embodiment, the burls within an independently controllable region 51 are provided with a common sensor 65.

By increasing the number of sensors, the level of detail of sensing of the bond force may be increased. By reducing the number of sensors 65, the complexity of the substrate holder 170 may be reduced. In an embodiment the sensors are configured to output a bond force signal indicative of a bond force and/or location during the bonding.

In an embodiment the sensor 65 is a piezoelectric sensor. In an embodiment the sensor 65 comprises piezoelectric material sandwiched by electrodes 64, 66 as shown in Figure 11. When a force such as the bond force acts on the substrate 110, the force may cause the piezoelectric material of the sensor 65 to expand or compress. The expansion or compression of the piezoelectric material of the sensor 65 results in an electric field (or a change in electric field) inducing a change in the potential difference between the electrodes 64, 66 that sandwich the piezoelectric material. By measuring the change in the potential difference, the compression or expansion of the piezoelectric material may be monitored, thereby providing a signal indicative of the force applied to the substrate 110.

By measuring the bond force during the bonding process, it may be possible to track the position of the bond front. By tracking the position of the bond front during the bonding process, it may be possible to more accurately adjust the clamping force at the correct time. For example, in an embodiment the controller is configured to reduce (e.g. switch off) the clamping force when the bond force is greater than or equal to a threshold bond force. That is, when a particular region of the first substrate and the second substrate is sufficiently close to the bond front, the clamping force may be reduced (e.g. switched off). An embodiment of the invention is expected to increase the accuracy of control of propagation of the bond front.

In an embodiment the sensors 65 are configured to detect the pull of the adhesive surfaces of the first substrate and the second substrate. The sensors 65 increase the accuracy of determination of where the bond front is located. The measurement of the bond force has an increase in accuracy of the control of the bond front. Once the first substrate and the second substrate are bonded together, the clamping force is no longer needed. In an embodiment the controller is configured to generate data for a two-dimensional map of the location of the bond front during the bonding process.

Figure 11 shows an arrangement in which the sensors 65 are provided in a substrate holder 170 that performs electrostatic clamping. It is not essential for the sensors 65 to be provided with electrostatic clamping. For example, the sensors 65 may be omitted. In an alternative embodiment, the sensors 65 are provided to a substrate holder 170 of the type shown in Figure 5, in which vacuum clamping is applied.

As shown in Figure 11, in an embodiment the substrate holder 170 comprises a plurality of actuators 63. The actuators 63 are configured to actuate the burls 67. For example, the actuators 63 may be configured to adjust the extent by which the burls 67 protrude from the base surface 53 of the substrate holder 170. The actuators 63 may be configured to move the distal ends 52 of the burls 67 up and down, in the orientation shown in Figure 11.

As shown in Figure 11, in an embodiment a plurality of actuators 63 are provided for respective burls 67. In an embodiment, the burls 67 may be actuated substantially independently of each other. In an alternative embodiment, the burls 67 may be grouped into groups, with each group having a common actuator 63. For example, the burls 67 within an independently controllable region 51 may be provided with a common actuator 63. In an embodiment the actuation of burls 67 is independently controllable for each independently controllable region 51.

As shown in Figure 11, in an embodiment the actuator 63 is a piezoelectric actuator. The actuator 63 may comprise a piezoelectric material sandwiched by electrodes 62, 64. As shown in Figure 11, in an embodiment one of the electrodes that sandwiches the piezoelectric material of the actuator 63 is the clamping electrode 62.

In an embodiment an electric power supply is configured to control the potential difference between the electrodes 62, 64 that sandwich the piezoelectric material of the actuator 63. By controlling the potential difference between the sandwiching electrodes 62, 64, the electric field that penetrates the piezoelectric material may be controlled, thereby controlling compression for expansion of the piezoelectric material of the actuator 63. The compression or expansion of the piezoelectric material results in the distal end 52 of the burl 67 moving up or down, in the orientation shown in Figure 11.

In an embodiment the substrate holder 170 is configured such that the clamping force is controllable independently of the actuation by the actuator 63. For example, the clamping electrode 62 may have its electric potential controlled so as to control the clamping force. The electric potential applied to the opposing electrode 64 may be controlled so as to control the potential difference between the clamping electrode 62 and the opposing electrode 64. The potential difference between the clamping electrode 62 and the opposing electrode 64 determines the actuation by the actuator 63.

In an embodiment the controller is configured to control the bond front by controlling the clamping force and the actuators 63. The actuators 63 may be controlled so as to control how the bond partners are brought together. The actuators 63 may be controlled so as to control movement of the substrates relative to each other (e.g. moving the substrates closer together).

In an embodiment the controller is configured to control the bond front by maintaining the clamping force (e.g. keeping the potential difference between the electrodes 62, 64 substantially constant) and controlling the actuators 63 (e.g. varying actuation).

It is not essential for the actuation to be varied to control the bond front. In an embodiment the controller is configured to control the bond front by controlling the clamping force while applying substantially no actuation via the actuators 63.

Figure 12 is a cross-sectional view through part of the substrate holder 170. Figure 12 shows the burls 67 corresponding to different independently controllable regions actuated by different extents. The burls 67 protrude by different amounts from the base surface 53 of the substrate holders 170, 180.

Figure 12 schematically depicts a first substrate 110 held by a first substrate holder 170 and a second substrate 120 held by a second substrate holder 180.

Towards the right-hand side of Figure 12, the burls 67a correspond to the central independently controllable area 51a. Moving towards the left, the burls 67b-r correspond to the burls of independently controllable regions 51 moving radially outwards from the centre of the substrate holder 170. For example, the burls 67p are within the independently controllable region 51p. The burls 67q are within the independently controllable region 51q. The burls 67r are within the independently controllable region 51r.

In an embodiment the controller is configured to control the actuation of the burls 67. For example, the controller may be configured to control the actuation of the burls 67 so as to correct the total thickness variation of the substrate 110 held by the substrate holder 170. The bonding surface 111 may be increased in flatness before the bonding process is performed.

As shown in Figure 12, during the bonding process, the shape of the substrate 110 may depend on the position of the bond front. The bond gap in Figure 12 is shown greatest furthest from the bond front, i.e. at the outer periphery of the bond. The bond gap generally decreases towards the bond front, where the bond gap becomes zero. In an embodiment the controller is configured to control the actuation of the burls 67 dependent on the location of the burls 67 relative to the bond front. In an embodiment the controller is configured to control the actuation of the burls 67 dependent on signals received from the sensors 65. The sensors 65 may indicate the location of the bond front. An embodiment of the invention is expected to increase accuracy of control of the bonding process.

In an embodiment the controller is configured to control actuation and clamping force associated with the burls 67 so as to re-open the bond in one or more locations. For example, when it is determined that there is a void or a particle trapped in the bond, the burls 67 in that location may be actuated and the clamping force increased so as to pull the first substrate away from the second substrate, thereby reopening the bond. The bond may then be allowed to re-close without trapping the void, for example.

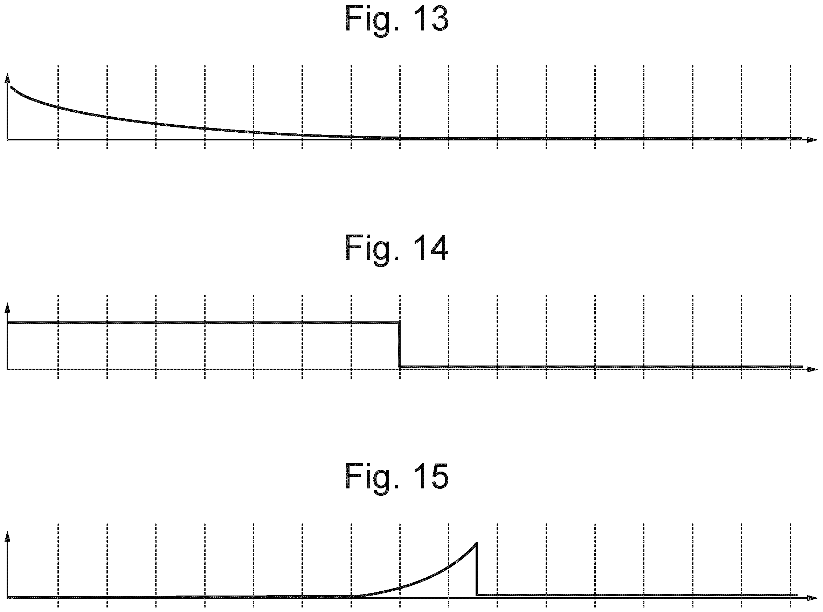

Figure 13 is a graph showing the relationship between position along the bond and the bond gap. In Figure 13, the left-hand side corresponds to the left-hand side of Figure 12. The right-hand side of Figure 13 corresponds to the right-hand side of Figure 12, namely the centre of the substrate holder 170. Figure 13 shows the bond gap increasing generally away from the bond front towards the periphery of the substrate holder 170.

Figure 14 is a graph showing the relationship between the position along the bond and the clamping force. In Figure 14, the left-hand side corresponds to the left-hand side of Figure 12, namely the periphery of the bond. The right-hand side of Figure 14 corresponds to the right-hand side of Figure 12, namely the centre of the bond. As shown in Figure 14, in an embodiment the controller is configured to control the clamping force to be switched off for regions that are close to the bond front and for regions where the bond has already been formed.

As shown in Figure 12, in an embodiment the controller is configured to perform a clamping force control 72. The controller is configured to perform the clamping force control 72 for the burls 67 corresponding to independently controllable regions 51.

As shown in Figure 12, in an embodiment the controller is configured to perform bond gap control. That is, the controller may be configured to control the clamping force and/or actuation of the burls 67 so as to control the bond gap. For example, the bond gap may be increased by reapplying the clamping force. The bond gap may be reduced by actuating the burls 67 to protrude further from the base surface 53 and/or by switching off the clamping force.

Figure 15 is a graph showing the relationship between position along the bond and the bond force. In Figure 15, the left-hand side corresponds to the left-hand side of Figure 12, namely the periphery of the bond. The right-hand side of Figure 15 corresponds to the right-hand side of Figure 12, namely the centre of the bond. As shown in Figure 15, the bond force is substantially zero where the first substrate is bonded to the second substrate. The bond force is greatest very close to the bond front, where the first substrate and the second substrate are close to each other but not bonded. The bond force gradually decreases further away from the bond front.

As shown in Figure 12, in an embodiment the controller is configured to receive bond force feedback 73 from the sensors 65 associated with the burls 67. In an embodiment the controller is configured to control the clamping force and/or the actuation of the burls 67 based on feedback from the sensors 65 about the bond force.

In Figure 11, the actuators 63 are shown in the context of an electrostatic clamp. In an alternative embodiment, the actuators 63 may be provided in the context of a vacuum clamp. For example, the actuators 63 shown in Figure 11 may be provided to the substrate holder 170 shown in Figure 5.

In Figure 11, the actuators 63 are shown together with the sensors 65. However, it is not necessary for the actuators 63 to be provided together with the sensors 65. In an alternative embodiment, the sensors 65 are provided without the actuators 63. In an alternative embodiment, the actuators 63 are provided without the sensors 65.

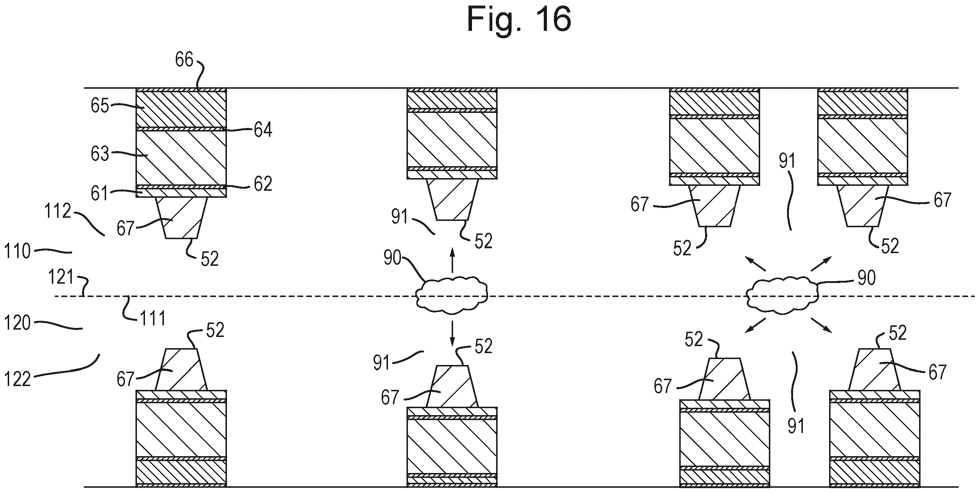

Figure 16 schematically depicts particle mapping within the bond plane. Figure 16 schematically shows three scenarios associated with burls 67 on either side of the bond. In Figure 16, the burls are shown together with their actuators 63 and sensors 65, but without the main body of the substrate holder 170. This is merely for clarity. The main body of the substrate holder 170 is present in the embodiment.

In the left-hand scenario of Figure 16, the first substrate 110 and the second substrate 120 are bonded to each other without any separation or void, for example. As a result, the sensor 65 senses a force value that corresponds (e.g. defines) a successful bond without any undesirable void or particle.

The central scenario shown in Figure 16 shows a particle 90 trapped in the bond. As a result of the trapping of the particle 90, the particle applies a force in the up and down directions (as indicated by the arrows extending away from the particle 90) on the first substrate 110 and the second substrate 120. This causes deformation 91 of the first substrate 110 and the second substrate 120. As a result of the deformation, forces are applied through the burls 67, as indicated by the arrows within the burls 67 shown in Figure 16. These forces cause the sensors 65 to sense a force value that is a combination of the force value sensed in the left-hand scenario (i.e. for a successful bond) together with the additional force as a result of the presence of the particle. An embodiment of the invention is expected to make it possible to sense the presence of a particle 90 trapped in the bond. In an embodiment the controller is configured to map the presence of particles within the bond plane.

The right-hand scenario shown in Figure 16 shows another particle 90 trapped in the bond plane. The right-hand scenario is different from the central scenario in that the particle 90 is trapped in a location between adjacent burls 67, rather than directly above/below an individual burl 67 (as shown in the central scenario). The trapping of the particle 90 causes deformation 91 of the first substrate 110 and the second substrate 120. This is caused by forces extending outwards from the particle 90, as shown by the arrows extending from the particle 90.

As a result of the deformation 91, forces both in the vertical directions and the lateral directions are applied on the burls 67 surrounding the particle 90. This leads to the sensors 65 detecting a force that is a combination of the average value that is sensed in the left-hand scenario together with an additional force component as a result of the deformation 91 caused by the presence of the particle 90. In general, the force caused by the deformation of the particle 90 sensed by the sensors 65 in the right-hand scenario is expected to be smaller than the force component due to the presence of the particle 90 in the central scenario, if the particles 90 are of the same size. In the right-hand scenario, the additional force component as a result of the particle 90 may be detected by adjacent burls 67 of the first substrate holder 170 and by adjacent burls 65 of the second substrate holder 180. It may be possible to distinguish between the right-hand scenario and the central scenario shown in Figure 16. An embodiment of the invention is expected to improve particle mapping in the bond plane.

Further embodiments of the invention are disclosed in the following list of numbered clauses:
1. A substrate holder for a bonding tool configured to bond a first substrate to a second substrate, the substrate holder configured to hold the first substrate and comprising:a plurality of burls protruding from a base surface of the substrate holder and configured to contact the first substrate, wherein the substrate holder is configured to clamp the first substrate to the substrate holder by a clamping force through the burls.
2. The substrate holder of clause 1, wherein the burls are configured to apply the clamping force pneumatically.
3. The substrate holder of clause 1 or 2, wherein the burls are provided with vacuum channels for pneumatically clamping the first substrate to the substrate holder.
4. The substrate holder of any preceding clause, configured to apply the clamping force electrostatically via an electric field that penetrates the burls.
5. The substrate holder of clause 4, comprising: a plurality of independently controllable clamping electrodes located such that the burls are between the clamping electrodes and the first substrate.
6. The substrate holder of any preceding clause, configured such that the clamping force is independently controllable for a plurality of regions of a holding surface of the substrate holder.
7. The substrate holder of clause 6, wherein a plurality of the regions correspond to respective radii from a centre of the holding surface.
8. The substrate holder of any preceding clause, comprising: a plurality of sensors configured to sense a force applied to the first substrate during bonding to the second substrate.
9. The substrate holder of clause 8, wherein the sensors are configured to output a bond force signal indicative of a bond force and/or location during the bonding.
10. The substrate holder of clause 8 or 9, wherein the sensors are configured to output a bond separation signal indicative of a separation between the first substrate and the second substrate during the bonding.
11. The substrate holder of any of clauses 8-10, wherein the clamping force is controllable based on the sensed force.
12. The substrate holder of any preceding clause, comprising: a plurality of actuators configured to adjust an extent by which respective burls protrude from the base surface.
13. The substrate holder of clause 12, wherein the actuators are independently controllable.
14. The substrate holder of clause 12 or 13, wherein the actuators are controllable so as to increase flatness of a surface of the first substrate before the bonding.
15. The substrate holder of any preceding clause, comprising: a controller configured to control the clamping force.
16. The substrate holder of clause 15, wherein the controller is configured to control the clamping force so as to control progress of a bond front during the bonding.
17. The substrate holder of clause 15 or 16, wherein the controller is configured to control the clamping force so as to control a bond gap between the first substrate and the second substrate during the bonding.
18. The substrate holder of any of clauses 15-17, wherein the controller is configured to control the clamping force so as to control a speed of the bonding.
19. The substrate holder of any of clauses 15-18, wherein the controller is configured to control the clamping force so as to move a void between the first substrate and the second substrate during the bonding.
20. A holding system comprising: two of the substrate holder of any preceding clause configured to hold respective substrates that are to be bonded to each other.
21. A method for holding a first substrate to be bonded to a second substrate, the method comprising: contacting the first substrate with a plurality of burls protruding from a base surface of the substrate holder; and clamping the first substrate to the substrate holder by a clamping force through the burls.
22. A bonding tool for bonding a first substrate to a second substrate, the bonding tool comprising the substrate holder of any of clauses 1 to 19.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. The methods of the invention may be carried out on a computer system located in the same system as the first substrate holder and second substrate holder, or may be remote from the first substrate holder and second substrate holder. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A substrate holder for a bonding tool configured to bond a first substrate to a second substrate, the substrate holder configured to hold the first substrate and comprising:
a plurality of burls protruding from a base surface of the substrate holder and configured to contact the first substrate,
wherein the substrate holder is configured to clamp the first substrate to the substrate holder by a clamping force through the burls.

2. The substrate holder of claim **1,** wherein the burls are configured to apply the clamping force pneumatically.

3. The substrate holder of claim **1,** wherein the burls are provided with vacuum channels for pneumatically clamping the first substrate to the substrate holder.

4. The substrate holder of claim **1,** configured to apply the clamping force electrostatically via an electric field that penetrates the burls.

5. The substrate holder of claim 4, comprising:
a plurality of independently controllable clamping electrodes located such that the burls are between the clamping electrodes and the first substrate.

6. The substrate holder of claim **1,** configured such that the clamping force is independently controllable for a plurality of regions of a holding surface of the substrate holder.

7. The substrate holder of claim 6, wherein a plurality of the regions correspond to respective radii from a centre of the holding surface.

8. The substrate holder of claim **1,** comprising:
a plurality of sensors configured to sense a force applied to the first substrate during bonding to the second substrate.

9. The substrate holder of claim 8, wherein the sensors are configured to output a bond force signal indicative of a bond force and/or location during the bonding.

10. The substrate holder of claim 8, wherein the sensors are configured to output a bond separation signal indicative of a separation between the first substrate and the second substrate during the bonding.

11. The substrate holder of claim 8, wherein the clamping force is controllable based on the sensed force.

12. The substrate holder of claim **1,** comprising:
a plurality of actuators configured to adjust an extent by which respective burls protrude from the base surface.

13. A holding system comprising:
two of the substrate holder of any preceding claim configured to hold respective substrates that are to be bonded to each other.

14. A bonding tool for bonding a first substrate to a second substrate, the bonding tool comprising the substrate holder of claim 1.

15. A method for holding a first substrate to be bonded to a second substrate, the method comprising:
contacting the first substrate with a plurality of burls protruding from a base surface of the substrate holder; and
clamping the first substrate to the substrate holder by a clamping force through the burls.
